Europäisches Patentamt

**European Patent Office**

Office européen des brevets

(19)

(11) Veröffentlichungsnummer: **0 218 152**
**B1**

(12) **EUROPÄISCHE PATENTSCHRIFT**

(45) Veröffentlichungstag der Patentschrift:
05.12.90

(51) Int. Cl.⁵: **H03F 3/217**

(21) Anmeldenummer: **86113241.3**

(22) Anmeldetag: **26.09.86**

(54) Schaltverstärker.

(30) Priorität: **28.09.85 DE 3534679**

(43) Veröffentlichungstag der Anmeldung:
**15.04.87 Patentblatt 87/16**

(45) Bekanntmachung des Hinweises auf die Patenterteilung:
**05.12.90 Patentblatt 90/49**

(84) Benannte Vertragsstaaten:
**CH DE FR GB LI**

(56) Entgegenhaltungen:
**EP-A- 0 066 904**
**EP-A- 0 083 727**
**EP-A- 0 124 765**
**GB-A- 2 064 901**

(73) Patentinhaber: **Licentia Patent-Verwaltungs-GmbH,
Theodor-Stern-Kai 1, D-6000 Frankfurt/Main 70(DE)**

(72) Erfinder: **Lodahl, Manfred, Dipl.-Ing.,
Spindelmühlerweg 6, D-1000 Berlin 45(DE)**

(74) Vertreter: **Schulze, Harald Rudolf, Dipl.-Ing. et al,
Licentia Patent-Verwaltungs-GmbH
Theodor-Stern-Kai 1, D-6000 Frankfurt/Main 70(DE)**

## Beschreibung

Die Erfindung betrifft einen Schaltverstärker nach dem Oberbegriff des Patentanspruchs 1.

In der deutschen Offenlegungsschrift DE-A 1 816 530 ist ein Niederfrequenzverstärker hoher Ausgangsleistung beschrieben, der für Modulation einer Endstufe von Hochfrequenz-Nachrichtensendern geeignet ist. Der Verstärker besteht aus einer Mehrzahl von mit einem gemeinsamen Arbeits-widerstand zusammenwirkenden gesteuerten Bau-elementen mit vorzugsweise untereinander gleichen Stufen. Die Steuerung der Bauelemente von dem einen in den anderen Zustand bei Änderung der Steuergröße für die einzelnen Bauelemente erfolgt in zeitlicher Folge derart, daß die Summe ihrer Ausgangsgrößen im wesentlichen eine analoge Widergabe der Steuergröße ist. Die gesteuerten Bauelemente liegen mit dem Arbeitswiderstand in Reihe, wobei die gesteuterten Bauelemente an Spannungsquellen geringen Innenwiderstands liegen und für den Nutzstrom durchlässige Richtleiter in die Strompfade von den Anschlüssen der Spannungsquellen zu den Verbindungspunkten zwischen je zwei der gesteuerten Bauelemente eingeschaltet sind. Die Größe der Ansteuerungsspannung ist gleich der der Ausgangsspannung wodurch für die jweiligen Teilspannungen ein linearer Zusammenhang zwischen der steuerbaren Spannung und der Ausgangsspannung erreicht werden soll. Eine solche Auslegung hat nicht nur den Nachteil der sehr großen Steuerspannung, sondern stellt auch enorm hohe Anforderungen an die Grenzfrequenz der Bauteile. Die Realisierung dieser Anforderungen läßt sich bei Verwendung von gesteuerten Halbleitern bei diesem Ver-stärker als Modulationsverstärker von Rundfunk-sendern großer Leistung (ungefähr 500 kW) kaum verwirklichen. Auch hat die angegebene Schaltung den Nachteil, daß die Spannungsbeanspruchung der Richtleiter sehr groß ist.

Günstiger ist eine Anordnung von Teilspannungsquellen in der derzeit üblichen Form von in Kaskade geschalteten Spannungsquellen, bei denen die Spannungsbeanspruchung der als Freilaufdiode dienenden Richtleiter gleich ist. Von einer solchen Anordnung in der Anwendung als Niederfrequenzverstärkern wird in der Offenlegungsschrift DE-OS 30 44 956 A1 und in der Europäischen Patentanmeldung 0 066 904 A1 ausgegangen.

Bei dem in der Offenlegungsschrift DE-A 30 44 956 A1 beschriebenen Verstärker werden die in Kaskade geschalteten Teilspannungsquellen von einem getakteten oder ungetakteten A/D-Wandler ein- oder ausgeschaltet, der von einem analogen Signal angesteuert wird. Damit ein dem Eingangssignal analoges Ausgangssignal und kein Treppensignal mit grober Stufung erzeugt wird, ist in Reihe zu den Teilspannungsquellen eine Verstärkeranordnung geschaltet, die von einem Fehlersignal gesteuert wird, das aus der Differenz von Eingangssignal und Ausgangssignal der Kaskadenschaltung von Teilspannungsqeullen gewonnen wird. Diese Schaltung weist insofern große Nachteile in der Anwen-dung als Niederfrequenzverstärker für die erwähn-ten großen Leistungen auf, als durch die mit Verzögerung behafteten Pegelerfassung des AD-Wandlers, der mit Schaltzeitfehlern behafteten Ein- und Ausschaltungen der Teilspannungsquellen sowie einer unberücksichtigt bleibenden Schwankung der Versorgungsspannung für die Teilspannungsquellen die Verstärkerschaltung zur Signalkorrektur überfordert ist, ein verzerrungsarmes Ausgangssignal zu liefern, wie es für die Modulation der Hoch-frequenz-Endstufe von Rundfunksendern erfor-derlich ist.

In dieser Offenlegungsschrift ist außerdem eine Verstärkerschaltung mit einer binären Staffelung von Teilspannungen angegeben. Eine solche Anordnung ist wegen der begrenzten Spannungsfestigkeit von Halbleitern nur für Verstärker mit kleiner Leistung (kleiner als 10 kW) geeignet, in keinem Fall aber als Halbleitermodulationsverstärker für Rundfunksender großer Leistung.

Der in der Europäischen Patentanmeldung EP-A 0 066 904 A1 angegebene Schaltverstärker hat einen ähnlichen Aufbau von Teilspannungsquellen wie der in der vorher erwähnten Offenlegungsschrift Auch hier wird ein getakteter A/D-Wandler für die Steuerung der Teilspannungsquellen benutzt. Die Korrektur des grobgestuften Treppensignals der Ausgangsspannung wird bei dem hier beschriebenen Schaltverstärker dadurch angestrebt, daß zur Feinstufung eine Verstärkerstufe in Unterstufen unterteilt wird, deren Ausgangsspannungen binär gewichtet sind. Es wird ferner erwähnt daß eine weitere Möglichkeit der Korrektur des grobgestuften Treppensignals über ein zeitverzögertes Steuersignal besteht.

In dem beschriebenen Schaltverstärker können nichtlineare Verzerrungen entstehen, insbesondere bei höheren Frequenzen, die größen sind, als es die internationale Norm für diese Qualitätsbestimmungen für Rundfunksender zuläßt. Wegen der Schaltzeitfehler von Halbleiterschaltern ist eine in der beschriebenen Weise angestrebte Verbesserung des Treppenstufencharakters nur für niedrige Frequenzen möglich. Damit eine Verbesserung der Ausgangsspannung über ein verzögertes Steuersignal möglich ist, darf die Taktfrequenz für den A/D-Wandler nicht zu hoch sein. Dies steht aber grundsätzlich im Widerspruch zur Absicht der Übertragung hoher Frequenzen. Die Ausgangsspannung ist wegen der unvermeidlichen Schaltfehler bei den Halbleiterschaltern, insbesondere bei hohen Frequenzen, mit Amplitudenfehlern behaftet, die systembedingt zum Null-Spannungswert der analogen Wechselspannung unsymmetrisch sind. Eine Unsymmetrie des Ausgangssignals wirkt sich als hoher Klirrfaktor beim Ausgangssignal aus.

Der Erfindung liegt daher die Aufgabe zugrunde, einen gattungsgemäßen Schaltverstärker anzugeben,

- der als digital arbeitender Modulationsverstärker insbesondere in Rundfunksendern mit unterschiedlichen Betriebsarten einsetzbar ist. insbesondere bei einer Amplitudenmodulation (AM) oder einer dynamikgesteuerten Amplitudenmodulation (DAM) oder bei Einseitenbandbetrieb (SSB) oder bei Teil- oder Volleistung in diesen Betriebsarten und
- der in diesen Betriebsarten einen hohen Wirkungsgrad besitzt bei möglichst geringen Verzerrungen des Ausgangssignals.

Diese Aufgabe wird gelöst durch die im kennzeichnenden Teil des Patentanspruchs 1 angegebenen Merkmale. Zweckmäßige Ausgestaltungen und/oder Weiterbildungen sind den Unteransprüchen entnehmbar.

Bei der Erfindung werden die geringen Verzerrungen des Ausgangssignal des digitalen Verstärkers dadurch erreicht, daß in Abhängigkeit von der Amplitude des Niederfrequenzsignals nur Teilspannungswerte ein- und ausgeschaltet werden, wie dies im Hinblick auf vorgebbare Verzerrungen zulässig ist. Gleichzeitig wird die Zahl der Schaltvorgänge zur Vermeidung einer hohen Verlustleistung in den Schaltelementen drastisch reduziert, ohne daß dies einen störenden Einfluß auf die Linearität des Ausgangssignals hat.

Ein wesentliches Merkmal der Erfindung ist die Wandlung des positiven und des negativen Teils der Niederfrequenzspannung in getrennte Digitalwerte.

Zur weiteren Verbesserung der Linearität des Schaltverstärkers sind Linearisierer für den Trägerwert sowie den positiven und negativen Niederfrequenzwert vorgesehen.

Durch diese Maßnahmen wird verhindert, daß sich Schaltzeitfehler als unsymmetrische Amplitudenfehler des Ausgangssignals auswirken, was in störender Weise einen hohen Klirrfaktor zur Folge hätte.

Ein sicherer Betrieb mit hoher Schaltfrequenz und geringen Verlusten in den Halbleiterschaltern wird dadurch erreicht, daß eine Einrichtung zur Spitzenstrombegrenzung vorgesehen ist. Durch diese Maßnahme wird der im wesentlichen durch die Kommutierungseigenschaften der in Kaskade geschalteten Halbleiterdioden bedingte hohe Spitzenstrom der Halbleiterschalter begrenzt.

Um selbst bei hoher Schaltfrequenz die Verluste der elektronischen Schalter gering zu halten, werden im Bedarfsfall zwei in Reihe geschaltete Halbleiterschalter oder die Parallelschaltung von jeweils zwei in Reihe geschalteten Halbleiterschalter verbunden mit einem geeigneten Steuerungsalgorithmus vorgesehen.

Schaltungstechnisch wird die Realisierung dieser Systemmerkmale dadurch gelöst, daß die Niederfrequenzspannung und der Gleichspannungswert (Trägerwert) von A/D-Wandlern getrennt verarbeitet werden. Damit läßt sich unabhängig von der Betriebsart das Niederfrequenzsignal nach Amplitude und Polarität detektieren.

Eine weitere Verbesserung der Linearität des Schaltverstärkers wird durch Linearisierer erreicht. Diese Schaltungsmittel enthalten im wesentlichen programmierbare Logikbausteine, die zwischen den Eingangssignalen und den Ausgangssignalen des Schaltverstärkers einen linearen Zusammenhang herstellen.

Um einen hohen Wirkungsgrad des Schaltverstärkers zu gewährleisten, werden die Spannungssprünge des Ausgangssignals möglichst groß gewählt, damit die Schaltverluste von Teilspannungsquellen so niedrig wie möglich sind; andererseits aber müssen die Spannungssprünge so klein wie nötig sein, damit die Forderungen an die zulässigen Verzerrungen des Schaltverstärkers erfüllt werden. Dieses Schaltungsprinzip beinhaltet eine von der Niederfrequenzamplitude abhängige Steuerung der Teilspannungsquellen.

Als Maximalspannungswert ist dabei derjenige Spannungswert zu verstehen, der aufgrund einer gegebenen Schaltung der Teilspannungsquellen und der darin verwendeten Bauteile unter Berücksichtigung eines Sicherheitsfaktors der maximale Spannungswert der Teilspannungsquellen ist.

Die Teilspannungsquellen haben unterschiedliche Spannungen, sie sind der zu verstärkenden Spannung amplitudenmäßig zugeordnet. Je größer der zu verstärkende Spannungswert ist, desto größer ist auch die diesem Pegel zugeordnete Teilspannung. Es wird immer diejenige Teilspannungsquelle ein- oder ausgeschaltet, die dem zu verstärkenden Spannungswert entspricht. Die Staffelung der Teilspannungen ist so gewählt, daß ein vorgegebenes Maß an Verzerrungen nicht überschritten wird. Bei sehr kleinen Pegelwerten braucht die Staffelung der Teilspannungen nur so klein zu sein, daß der zulässige Fremdspannungswert von den Verzerrungskomponenten nicht überschritten wird. Aus technischen Gründen kann es nötig sein, Gruppen von gleichen Teilspannungsquellen zu bilden, wodurch sich allerdings die Zahl der Teilspannungsquellen erhöht. Bei einem solchen spannungsgesteuerten Schaltverstärker ist die Zahl der Ein- und Ausschaltungen der einzelnen Teilspannungsquellen minimal, wodurch die zu übertragende Frequenz sehr hoch sein kann. Die Schaltverluste sind dabei relativ klein im Vergleich zur Ausgangsleistung.

Das Prinzip eines derartigen spannungsgesteuerten Digitalverstärkers ist auch bei einer binären Staffelung der Teilspannungen anwendbar. Dies wird dadurch erreicht, daß eine Schaltlogik das Ein- oder Ausschalten der niederwertigen binären Teilspannungsquellen bei größeren Signalspannungen verhindert und damit wie bei der Staffelung der Teilspannungsquellen mit direkter Signalspannungszuordnung im Bereich kleiner Signalspannungswerte kleine Änderungen und im Bereich großer Signalspannungswerte große Änderungen der Ausgangsspannung des Digitalverstärkers erfolgen.

Bei einem Digitalverstärker großer Leistung ist es zweckmäßig, eine Kombination von spannungsgesteuerten Teilspannungsquellen mit direkter Zuordnung zum Signalspannungspegel und spannungsgesteuerten binär gewichteten Teilspannungsquellen vorzunehmen, da dadurch die Anzahl der Teilspannungsquellen klein gehalten wird und gleichzeitig große Ausgangsspannungen des Digitalverstärkers möglich sind.

Die Erfindung wird im folgenden anhand eines Ausführungsbeispiels näher erläutert unter Bezugnahme auf schematische Zeichnungen. Es zeigen:

FIG. 1 ein schematisches Blockschaltbild des Ausführungsbeispiels

FIG. 2 bis 8 Ausführungsbeispiele zur Erläuterung der Funktion der Blöcke gemäß Fig. 1.

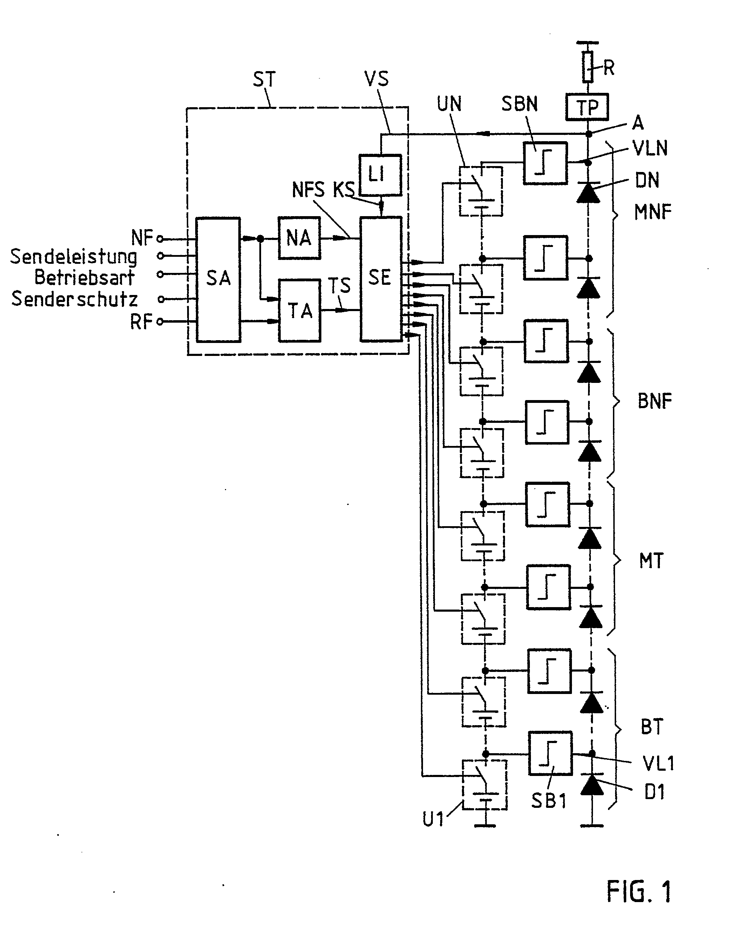

Fig. 1 zeigt eine Diodenkaskade, bestehend aus einer Reihenschaltung von Freilaufdioden D1 bis DN, deren ein Ende an Masse liegt, daß heißt geerdet ist und deren anderes Ende den Ausgang A des Schaltverstärkers bildet. Der Ausgangs A ist über ein Tiefpaßfilter TP an eine Last R angeschossen, z.B. eine amplitudenmodulierbare Endstufen-Elektronenröhre eines Hochfrequenz-Hochleistungssenders von 500 kW Ausgangsleistung. Parallel zu der Diodenkaskade ist eine Reihenschaltung von schaltbaren Teilspannungsquelle U1 bis UN angeordnet. Diese bestehen z.B. jeweils aus einer Reihenschaltung aus einem Halbleiterschalter, z.B. Schalttransistoren oder Thyristoren, und jweils einer Spannungsquelle. Diese sind z.B. herstellbar mit Hilfe eines nicht dargestellten Dreiphasen-Hochspannungstransformators für ein 50 Hz-Netz. Die Teilspannungsquellen U1 bis Un und die zugehörigen Freilaufdioden D1 bis DN sind in der dargestellten Weise verbunden durch Verbindungsleitungen VL1 bis VLN, in denen jeweils ein Spitzenstrombegrenzer SB1 bis SBN vorhanden ist. Die Teilspannungsquellen U1 bis UN sind in zwei Gruppen unterteilt, eine Niederfrequenzgruppe BNF, MNF und eine Trägergruppe BT, MT. Jede dieser beiden Gruppen enthält jeweils eine Gruppe von Maximalspannungsquellen, die als Maximal-Trägergruppe MT und Maximal-Niederfrequenzgruppe MNF bezeichnet sind, und jeweils eine Gruppe von binär gewichteten Spannungsquellen die als Binär-Trägergruppe BT und Binär-Niederfrequenzgruppe BNF bezeichnet sind.

Die Summenspannung jeder der binär gewichteten Spannungsquellenanordnung BT bzw. BNF ist gleich der Spannung der zugehörigen Maximalspannungsquellen MT bzw. NMF, reduziert um den kleinsten binären Spannungswert. Die binären Spannungsquellen BT, BNF werden z.B. über einen nicht dargestellten Zwischentransformator mit Energie versorgt, der sekundärseitig mit so vielen Wicklungen bzw. Wicklungsanordnungen ausgestattet ist, wie binäre Niederfrequenz- oder Trägergruppen vorgesehen sind und der primärseitig an eine der sekundären Wicklungen des erwähnten Hochspannungstransformators angeschlossen ist.

Die Trägergruppen BT, MT liefern eine Ausgangsspannung des Schaltverstärkers, die vorzugsweise die halbe maximale Ausgangsspannung ist. Wenn sämtliche Niederfrequenz- und Träger-Maximalspannungsgruppen MNF, MT eingeschaltet sind, wird die maximale Ausgangsspannung erreicht. Das Ein- und Ausschalten der Teilspannungsquellen U1 bis UN erfolgt über eine Steuereinheit ST, welche die Steuerspannungen für die Teilspannungsquellen aufbereitet, an deren Niederfrequenzeingang NF das zu verstärkende Niederfrequenzsignal liegt, z.B. mit einer Bandbreite von 5 kHz, und an deren Hochfrequenzeingang RF ein Hochfrequenzträgersignal liegt, z.B. mit einer Frequenz von 10 MHz. Die Ein- und Ausschaltbefehle für die Niederfrequenzgruppen BNF, MNF werden von dem positiven Teil einer Niederfrequenz NF-Spannung abgeleitet. Am Anwendungsfall eines Modulationsverstärkers für Rundfunksender handelt es sich dabei um eine Spannung, die dem positiven Anteil der niederfrequenten Wechselspannung entspricht.

Dies ist bei Zweiseitenbandbetrieb (DSB) eine Spannung, die den positiven Anteil der Modulationsspannung und bei Einseitenbandbetrieb (SSB) dem Teil des SSB-Hüllkurvensignals, entspricht, der größer ist als der dem Trägerwert zugeordnete Hüllkurvenspannungswert.

Die Ein- und Ausschaltbefehle für die Trägergruppe BT, MT werden sowohl von einer Trägerspannung als auch von dem negativen Teil der NF-Spannung abgeleitet. Die NF-Spannung und die Träger-Spannung werden in einer Schaltung zur Spannungsaufbereitung der Steuereinheit ST gewonnen, der das NF- und Träger (RF)-Signal zugeführt wird und die die unterschiedlichen Betriebsarten eines Rundfunksender berücksichtigt. Diese Betriebsarten sind bei Zweiseitenbandbetrieb (DSB) Amplitudenmodulation (AM) und dynamikgesteuerte Amplitudenmodulation (DAM) sowie der Einseitenbandbetrieb (SSB). In beiden Betiebsarten ist der Sender im Teil- oder Vollastbetrieb betreibbar.

Der am Ausgang A der Diodenkaskade befindliche Tiefpaß TP dient in erster Linie bei dieser Anordnung zur Bandbegrenzung. Da wegen der spannungsgesteuerten digitalen Signalverstärkung die Ausgangsspannung eine sehr gute Annäherung an das Ursprungssignal ist, kann der Filteraufwand vorteilhafterweise klein gehalten werden. Hierdurch ist bis zu hohen Signalfrequenzen die bei Rundfunksendern übliche Hüllkurvengegenkopplung möglich, wodurch sich der Klirrfaktor erheblich verringern läßt.

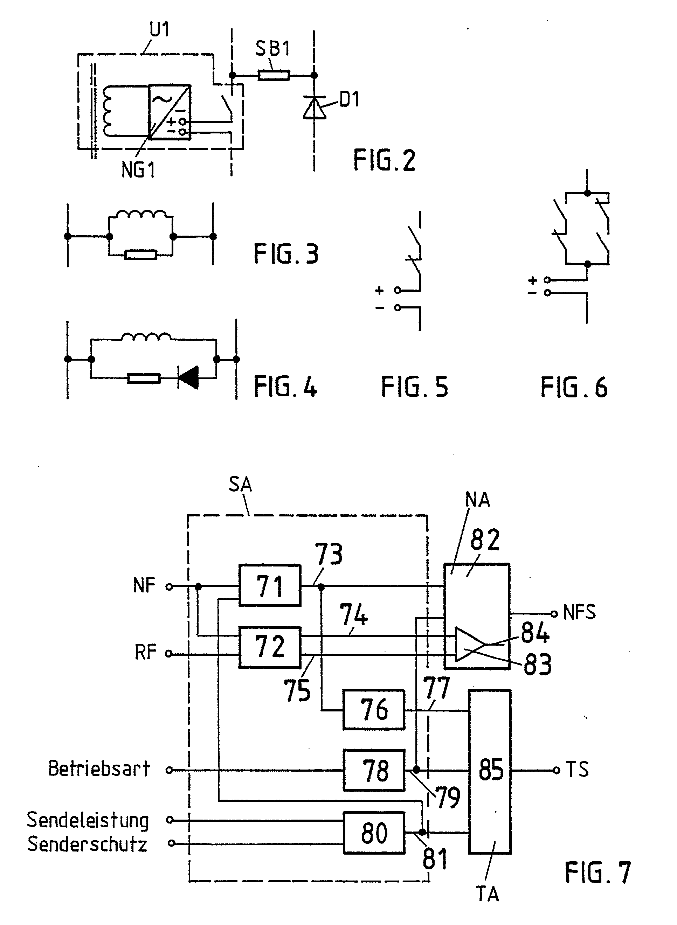

In Fig. 2 ist ein beispielhafter Aufbau einer der Teilspannungsquellen U1 bis UN gezeigt. Die angegebene Schalteranordnung ist eine steuerbare Halbleiterschaltung. Als Halbleiter sind z.B. Leistungstransistoren, Feldeffekttransistoren Thyristoren oder GTO's geeignet. Die beispielhaft gewählte Teilspannungsquelle U1 besitzt eine zugehörige Freilaufdiode D1, über die im Falle des gesperrten Halbleiterschalters der Strom des Schaltverstärkers fließt. Wenn sämtliche Teilspannungsquellen U1 bis UN ausgeschaltet sind, fließt kein Strom mehr. Mit NG1 ist ein vorzugsweise dreiphasiger Gleichrichter bezeichnet.

Durch die Spitzenstrombegrenzer SB1 bis SBN (Fig. 1) wird die im wesentlichen durch den Kommutierungsstrom der Freilaufdiode bedingte Stromspitze beim Einschalten der Schalteranordnungen begrenzt, wodurch bedeutend höhere Betriebsströme für die Teilspannungsquellen U1 bis UN möglich sind. Eine solche Einrichtung ist besonders vorteilhaft bei Teilspannungsquellen, die als Schalteranordnung Feldeffekttransistoren benutzen. In Fig. 2 besteht der Spitzenstrombegrenzer SB1 im einfachsten Fall aus einem ohmschen Widerstand. Ein anderes Ausführungsbeispiel für einen Spitzenstrombegrenzer ist eine Parallalschaltung von Widerstand und Spule (Fig. 3), wobei alternativ hierzu in einem oder in beiden Parallelkreisen in Reihe zu Widerstand und Spule noch eine Diode vorgesehen werden kann (Fig. 4).

Der Strombegrenzer ist zwischen dem Ausgang der Schalteranordnung und dem Ausgang der Freilaufdiode angeordnet.

In den Fig. 5 und 6 sind Ausführungsbeispiele für die Schalteranordnung angegeben. Im einfachsten Fall handelt es sich dabei um einen Halbleiterschalter in Reihe zum Gleichrichter. Durch die Reihenschaltung von zwei Halbleiterschaltern (Fig. 5) und einem geeigneten Steuerungsalgorithmus können die Schaltverluste der Schalteranordnung optimal auf zwei Halbleiterschalter verteilt werden.

Durch eine Parallelschaltung von zwei in Reihe geschalteten Halbleiterschaltern (Fig. 6) kann in Verbindung mit einem geeigneten Steuerungsalgorithmus nicht nur die Schaltleistung der Schalteranordnung gesteigert werden, sondern es kann außerdem noch die Schaltfrequenz zum Zwecke einer Verbesserung der Linearität des Schaltverstärkers erhöht werden. Die Steuerung kann in diesem Fall den bei Halbleiterschaltern besonders kritischen Fall des Wiedereinschaltens nach gerade erfolgter Ausschaltung vermeiden.

Für die Übertragung der Steuersignale von der Steuereinheit ST zu den Halbleiterschaltern der Teilspannungsquellen auf Hochspannungspotential sind z.B. Lichtwellenleiter (LWL) mit zugehörigen Lichtsendern und Lichtempfängern geeignet.

Fig. 7 zeigt ein Blockschaltbild mit einer genaueren Darstellung der in Fig. 1 schematisch dargestellten Block-Signalaufbereitung SA, Niederfrequenzaufbereitung NA und Trägeraufbereitung TA. In diesen Blöcken entstehen aus den zu verstärkenden NF-Signal und dem RF-Signal ein NF-Steuersignal NFS und ein Träger-Steuersignal TS. Diese Steuersignale werden der Schalteinheit SE zugeführt (Fig. 1). Gemäß Fig. 7 gelangt das zu verstärkende NF-Signal zu einer NF-Aufbereitungsschaltung 71 sowie einer SSB-Aufbereitungsschaltung 72, der außerdem ein RF-Signal zugeführt wird.

Die NF-Aufbereitung beinhaltet die bei Runfunksendern für diese Zwecke üblichen Schaltungsmittel wie z.B. Bandbegrenzer, Pegelsteller und Limiter. Es entsteht ein NF-Ausgangssignal 73. In der SSB-Aufbereitungsschaltung 72 wird aus RF- und NF-Spannung das SSB-Signal gewonnen, von dem das SSB-Hüllkurvensignal 74 abgeleitet wird. Außerdem wird von der SSB-Aufbereitung ein SSB-Trägerwertsignal 75 zur Verfügung gestellt, das in bestimmter spannungsmäßiger Zuordnung zum SSB-Hüllkurvensignal steht.

Aus dem NF-Ausgangssignal 73 wird in der DAM-Signal-Aufbereitung 76 ein DAM-Signal 77 erzeugt. Ferner sind in einer AM-Aufbereitungsschaltung 78 Schaltungsmittel zur Gewinnung eines hochstabilen AM-Signals 79 in Abhängigkeit von der Betriebsart vorgesehen sowie in einer Leistungsschaltung 80 solche zur Gewinnung eines Leistungssignals 81 für den Betrieb des Rundfunksenders mit unterschiedlichen Trägerleistungen, auf die auch Senderschutzeinrichtungen wirken.

In der NF-Spannungsaufbereitung 82 wird mittels eines Komparators 83 aus dem SSB-Hüllkurvensignal 74 und dem SSB-Trägerwertsignal 75 eine NF-SSB-Spannung 84 erzeugt die dem Hüllkurvensignal weitestgehend entspricht. Bei dieser Spannung 84 sind lediglich im Gegensatz zum SSB-Hüllkurvensignal 74 die Pegelwerte des Hüllkurvensignals, die größer als das SSB-Trägerwertsignal sind von positiver Polarität und die die kleiner als das SSB-Trägerwertsignal sind von negativer Polarität. Das SSB-Trägerwertsignal 75 ist ein vom SSB-Trägerwert abgeleiteter Pegelwert. Das NF-Steuersignal NFS wird bei DSB-Betrieb aus dem NF-Signal und bei SSB-Betrieb aus der NF-SSB-Spannung 84 in der NF-Spannungsaufbereitung 82 gewonnen.

Eine Träger-Spannungsaufbereitungsschaltung 85 stellt ein Träger-Steuersignal TS zur Verfügung, bei dem die unterschiedlichen Betriebsmöglichkeiten eines Rundfunksenders wie AM- DAM-, SSB-, Nenn- und Teilleistungsbetrieb berücksichtigt werden.

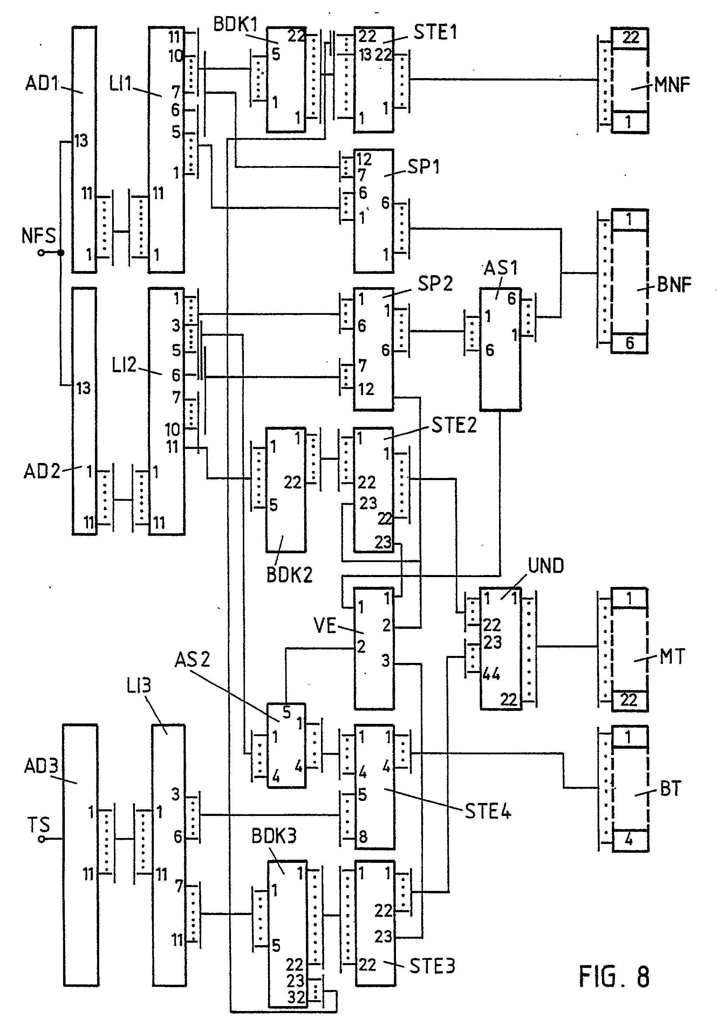

Fig. 8 zeigt ein genaueres Blockbild der Schalteinheit SE sowie des Linearisierers LI gemäß Fig. 1. Dabei ist der Linearisierer LI in der Betriebsart "Betrieb" dargestellt, so daß die in Fig. 1 dargestellte Verbindungsleitung für ein Vergleichssignal VS in Fig. 8 nicht vorhanden ist. Das Vergleichssignal VS wird lediglich für die Betriebsart "Programmierung" das Linearisierers benötigt. Die Funktionsweise des Linearisierers wird nachfolgend noch genauer erläutert.

Gemäß Fig. 8 werden durch das NF-Steuersignal NFS und das Träger-Steuersignal TS alle Teilspannungsquellen U1 bis UN angesteuert, wobei in diesem Beispiel N = 54 gewählt ist. Dabei enthält die Binär-Trägergruppe BT beispielsweise die vier Teilspannungsquellen U1 bis U4, welche die binär gewichteten Gleichspannungen 40V, 80V, 160V und 320V erzeugen. Die Maximalträgergruppe MT enthält beispielsweise die 22 Teilspannungsquellen U5 bis U26, wobei jede dieser Maximalspannungsquellen eine Gleichspannung von 640V erzeugt. Die Maximalniederfrequenzgruppe MNF enthält ebenfalls 22 Teilspannungsquellen, z.B. U 27 bis 48, die ebenfalls jeweils eine Gleichspannung von 640V erzeugen. Die Binär-Niederfreuenzgruppe BNF enthält sechs Teilspannungsquellen, z.B. U49 bis U54, welche die binär gewichteten Gleichspannungen 10V, 20V, 40V, 80V, 160V und 320V erzeugen.

Die Funktionsweise der Schalteinheit SE ist so, daß beim Anliegen eines Träger-Steuersignals TS binäre Träger-Spannungsquellen BT und Trägermaximalspannungsquellen MT entsprechend der Größe des Träger-Steuersignales TS eingeschaltet werden. Bei zusätzlich vorhandenem NF-Steuersignal NFS werden für negative Spannungswerte je nach ihren Pegeln Träger-Teilspannungsquellen BT, MT abgeschaltet. Dadurch ergibt sich eine Verringerung der Ausgangsspannung verglichen mit dem des Trägerwertes. Bei positivem NF-Steuersignal NFS werden zu der von dem Träger-Steuersignal vorgegebenen Anzahl von eingeschalteten Träger-Teilspannungsquellen BT, MT zusätzlich NF-Teilspannungsquellen BNF , MNF eingeschaltet. Dadurch ergibt sich eine Erhöhung des Ausgangsspannung verglichen mit der des Trägerwertes.

Das NF-Steuersignal NFS wird zwei A/D-Wandlern AD1, AD2 zugeführt; einer wandelt die positiven, der andere die negativen Werte des NF-Steuersignals NFS in Digitalwerte. Einem dritten A/D-Wandler AD3 wird das Träger-Steuersignal TS zugeführt. Es handelt sich hierbei beispielsweise um drei A/D-Wandler, bei denen 11 Bit zur Verfügung stehen. Die beiden A/D-Wandler AD1, AD2 für das NF-Steuersignal NFS können alternativ durch einen einzigen A/D-Wandler ersetzt werden, der mit einem Vorzeichen-Bit ausgestattet ist. Wegen der guten Übersicht halber der in Fig. 8 angegebenen Schaltungskonfiguration soll aber bei der Beschreibung der weiteren Funktionsweise der Steuerschaltung weiterhin von der Schaltung mit 3 A/D-Wandlern ausgegangen werden.

Ist die kleinste binäre Teilspannung Umin und die Anzahl der binären Niederfrequenz-Teilspannungen n, so ist die Gesamtspannung der n binären Teilspannungsquellen $(2^n-1)$Umin. Die Maximalspannungsquelle muß demzufolge die Spannung UMax = $2^n$ Umin haben. Die maximale Ausgangsspannung $U_{VMax}$ am Ausgang A des Schaltverstärkers wird dann erreicht, wenn sämtliche Maximalspannungsquellen MT, MNF eingeschaltet sind.

Ist 1 die Anzahl der Träger-Maximalspannungsquellen MT und k diejenige der NF-Maximalspannungsquellen MNF, so ist die Maximale Ausgangsspannung des Schaltverstärkers $U_{VMax}$ = (1 + k) . $2^n$.Umin.

Im Schaltungsbeispiel von Fig. 8 ist n = 6 und 1 = k = 22 gewählt worden. Damit ergibt sich

$$U_{VMax} = 2816 . UMin.$$

Den drei A/D-Wandlern AD1, AD2, AD3 sind Linearisierer LI1, LI2, LI3 nachgeschaltet, mit deren Hilfe zwischen den Träger- und NF-Steuersignalen und der Ausgangsspannung des Schaltverstärkers ein linearer Zusammenhang hergestellt wird.

Im einfachsten Fall handelt es sich bei den Linearisierern beispielsweise im wesentlichen um eine fest programmierte Logik, z.B. um einen programmierbaren Nurlesespeicher, der auch PROM ("programmable read only memory") genannt wird, deren Adressen digitalisierte Eingangswerte des NF-Steuersignals NFS sind und deren Speicherinhalte die digitalen Steuerspannungswerte für die Teilspannungsquellen angeben. Im erweiterten Fall kann eine programmierbare Logik vorgesehen werden, bei der je nach Bedarf eine Steuerlogik sogenannte Routinen druchführt und so den Speicherinhalt der programmierbaren Logik aktualisiert. In der Programmierroutine wird die Ausgangsspannung des Schaltverstärkers in einem bestimmten Teilverhältnis für Träger- und NF-Spannung mittels einer oder mehrerer weiterer A/D-Wandler festgestellt und dieser Wert als Adresse der programmierbaren Logik (z.B. RAM) angegeben. Die Speicherwerte dieser Adressen sind die durch den jeweiligen A/D-Wandler der Steuerschaltung digitalisierten Steuerspannungswerte. Nach Abschluß der Einleseroutine beinhalten die Speicherwerte die für die Linearisierung benötigten Pegelwerte. Im Betriebsfall werden die Adressen der programmierbaren Logik von den Ausgangswerten der A/D-Wandler der Steuerschaltung aufgerufen und die Speicherinhalte dieser Logik als Steuerinformation den Spannungsbewertern und Konvertern der Schalteinheit zugeführt. Auf diese Weise werden die Übertragungseigenschaften des gesammten Schaltverstärkers berücksichtigt und korrigiert.

An die Ausgänge Bit 1 bis Bit 6 der dargestellten Linearisierer LI1, LI2 für das NF-Steuersignal werden Spannungsbewerter Sp1, Sp2 und an die entsprechenden Ausgänge des Linearisierers LI3 für die Träger-Spannung (im Beispiel Bit 3 bis Bit 6) ein Steuerteil STE4 für die binären Teilspannungsquellen angeschlossen. Die Ausgänge Bit 7 bis Bit 11 sämtlicher Linearisierer LI1, LI2, LI3 werden mit den Eingängen von binär/dezimal-Konvertern BDK1, BDK2, BDK3 verbunden. Außerdem werden den Ausgängen Bit 6 bis Bit 11 der Linearisierer LI1, LI2 für das NF-Steuersignal Informationen zur Bewertung der digitalen Spannungswerte von Bit 1 bis Bit 6 entnommen. An die Ausgänge der Spannungsbewerter SP1, SP2 sind die Steuerleitungen der binären Teilspannungsquellen BNF angeschlossen, wobei dem Spannungsbewerter SP2 eine erste Aktivierungsschaltung AS1 nachgeschaltet ist. In einer einfachen Schaltungsausführung erfolgt die Spannungsbewertung so, daß HIGH-Potential am Ausgang Bit 6 und der höherwertigeren Bit's den Digitalwert von Ausgang Bit 1 so bewertet, daß dauernd LOW-Potential oder dauernd HIGH-Potential am entsprechenden Ausgang 1 des Spannungsbewerters das dauernde Abschalten oder das dauernde Einschalten der niederwertigsten binären Teilspannungsquellen (Teilspannungsquelle 1) bewirkt, daß HIGH-Potential am Ausgang Bit 7 und höherwertiger Bit's die Digitalwerte der Ausgänge von Bit 1 und Bit2 so bewertet, daß dauernd LOW-Potential oder dauernd HIGH-Potential an den entsprechenden Ausgängen 1 und 2 des Spannungsbewertes das dauernde Abschalten oder dauernde Einschalten der binären Teilspannungsquellen 1 und 2 bewirkt usw; daß HIGH-Potential am Ausgang Bit 11 die Digitalwerte der Ausgänge von Bit 1, 2, 3, 4, 5, 6 so bewertet, daß dauernd LOW-Potential oder dauernd HIGH-Potential an den entsprechenden Ausgängen 1, 2, 3, 4, 5, 6 des Spannungsbewerters das dauernde Abschalten oder dauernde Einschalten aller binärer Teilspannungsquellen bewirkt.

Die an den Ausgängen Bit 7 bis Bit 11 der Linearisierer LI1, LI2 angeschalteten binär dezimal-Konverter BDK1, BDK2 wandeln den Digitalwert dieser Ausgänge in eine Dezimalzahl um, von der in diesem Schaltungsbeispiel nur die Zahlen 1 bis 22 verwertet werden.

Bei dem Konverter BDK3 für den Träger werden sämtliche 32 Ausgänge beschaltet. Damit ist es bei Änderung der Zuordnung der Steuerleitungen zu den Teilspannungsquellen bei SSB-Betrieb mit Hüllkurvensteuerung im Vergleich zu den anderen Betriebsarten möglich, den Trägerwert größer als die halbe maximale Ausgangsspannung des Schaltverstärkers zu machen.

Da die NF-Steuersignale bei SSB-Betrieb mit Hüllkurvensteuerung kleiner sind als bei DSB-Betrieb, werden für die maximale 10 zusätzlichen Träger-Maximalspannungsquellen die höherwertigen NF-Maximalspannungsquellen genommen.

Die Ausgänge der Konverter BDK1, BDK2, BDK3 führen zu Steuerteilen STE1, STE2, STE3, deren Ausgänge im Falle des Steuerteils STE1 direkt und im Falle der Steuerteile STE3 und STE2 über eine logische UND-Verknüpfung UND mit den Steuerleitungen der Maximalspannungsquellen MNF, MT verbunden sind.

Das Steuerteil STE1 wertet die Pegelinformation des vorgeschalteten Konverters BDK1 aus und schaltet entsprechend den Pegelwert des positiven NF-Steuersignales die benötigte Zahl von NF-Maximalspannungsquellen MNF ein. Bei SSB-Betrieb erfolgt auch noch zusätzlich eine Auswertung des Konverters BDK3.

Bei dem Steuerteil STE2 wird zusätzlich zu der Pegelinformation des vorgeschalteten Konverters BDK2 eine Pegelinformation des Spannungsbewertes SP2 berücksichtigt, die darin besteht, daß dem Steuerteil STE2 immer dann ein HIGH-Potential geliefert wird, wenn an wenigstens einem der Ausgänge Bit 1 bis Bit6 des Linearisierers LI2 ein Ausgang auf HIGH-Potential liegt. Damit wird bewirkt, daß bei Ausgangsspannungswerten, die kleiner als der Trägerwert sind und die unter Zuhilfenahme von binären NF-Spannungsquellen gebildet werden, der Spannungswert allein der Träger-Maximalspannungsquellen stets kleiner ist, als es dem von der negativen NF-Spannung vorgesehenen Pegelwert entsprechen würde und durch Zuschalten von binären NF-Spannungsquellen der gewünschte Spanungswerte erreicht wird. Damit die auf den Trägerwert bezogene negative Ausgangsspannung symmetrisch zu der positiven Ausgangsspannung ist, sorgt der Spannungsbewerter SP2 dafür, daß mit größerer negativer Amplitude des NF-Steuersignals entsprechend dem Pegelbewertungsschema immer weniger binäre NF-Teilspannungsquellen abgeschaltet werden bis schließlich im Granzfall bei großem negativen NF-Steuersignal sämtliche binären NF-Teilspannungsquellen dauernd eingeschaltet bleiben. In diesem Zustand repräsentiert die Gesamtheit der binären NF-Teilspannungsquellen ersatzweise eine Maximalspannungsquelle, die beim größten zu verarbeitenden negativen Wert des NF-Steuersignales ingesamt abgeschaltet wird und auch bei Übersteuerung abgeschaltet bleibt.

Die binären Trägerspannungsquellen BT dienen der genauen Trägerwerteinstellung und sorgen bei DAM-Betrieb dafür, daß die Randaussendungen des Rundfunksenders, hervorgerufen durch den Modulationsprozeß, ein zulässiges Maß nicht überschreiten. Der Ausgangspegel bei DAM-Betrieb wird somit unter Zuhilfenahme von zwei binären Teilspannungsanordnungen (binäre Trägerspannungen und binäre NF-Spannungen) gebildet.

Der Trägerwert, einschließlich der bei DAM-Betrieb, bewegt sich bei so hohen Spannungswerten, daß es ausreichend ist, die binäre Stufung der Trägerspannung auf 4 Bit zu beschränken. Die binären Träger-Spannungsquellen werden von der negativen NF-Steuerung nacheinander abgeschaltet, wenn sämtliche Träger-Maximalspannungsquellen vorher abgeschaltet werden.

Die Steuerung der binären Träger-Spannungsquellen BT erfolgt durch ein Steuerteil STE4, an dessen Eingänge vier Ausgänge des Linearisierers LI2 (Bit 3 bis Bit 6) und vier Ausgänge des Linearisierers LI3 für den Träger (Bit3 bis Bit 6) angeschlossen sind. Diese insgesamt acht Verbindungen sind die Adreßleitungen eines Speichers im Steuerteil STE4. Im Speicher steht zugehörig zu der jeweiligen Adresse der Pegelwert, der sich aus der Differenz des Trägerwertes von Bit 3 bis Bit 6 und des NF-Negativ-Wertes von Bit 3 bis Bit 6 ergibt.

Durch einen Pegelvergleich von Spannungsbewerter SP2 und Steuerteil STE2 einerseits und dem Steuerteil STE3 für den Träger andererseits in einem Vergleicher VE wird festgestellt, wenn die letzte Träger-Maximalspannungsquelle von dem NF-Steuersignal abgeschaltet wird, um dann die den NF-negativ-Wert führenden Adreßleitungen mit Hilfe der Aktivierungsschaltung AS2 zum Speicher (Steuerteil STE4) durchzuschalten, wodurch das Abschalten der binären Träger-Spannungsquellen eingeleitet wird. Gleichzeitig wird durch den Vergleicher das Einschalten der binären NF-Spannungsquellen mit Hilfe der Aktivierungsschaltung AS1 verhindert.

Die Erfindung ist nicht auf das beschrieben Ausführungsbeispiel beschränkt, sondern sinngemäß auf weitere anwendbar. Beispielsweise ist es möglich, die in Fig. 8 dargestellte Schaltungsanordnung vollständig durch einen entsprechend programmierten Rechner zu ersetzen.

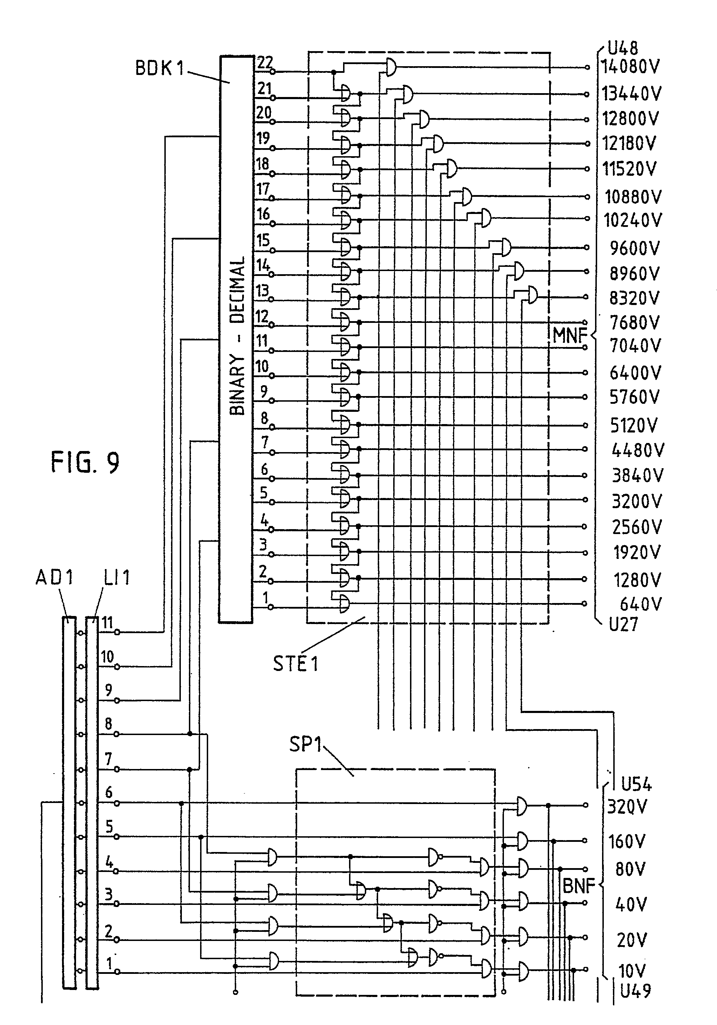

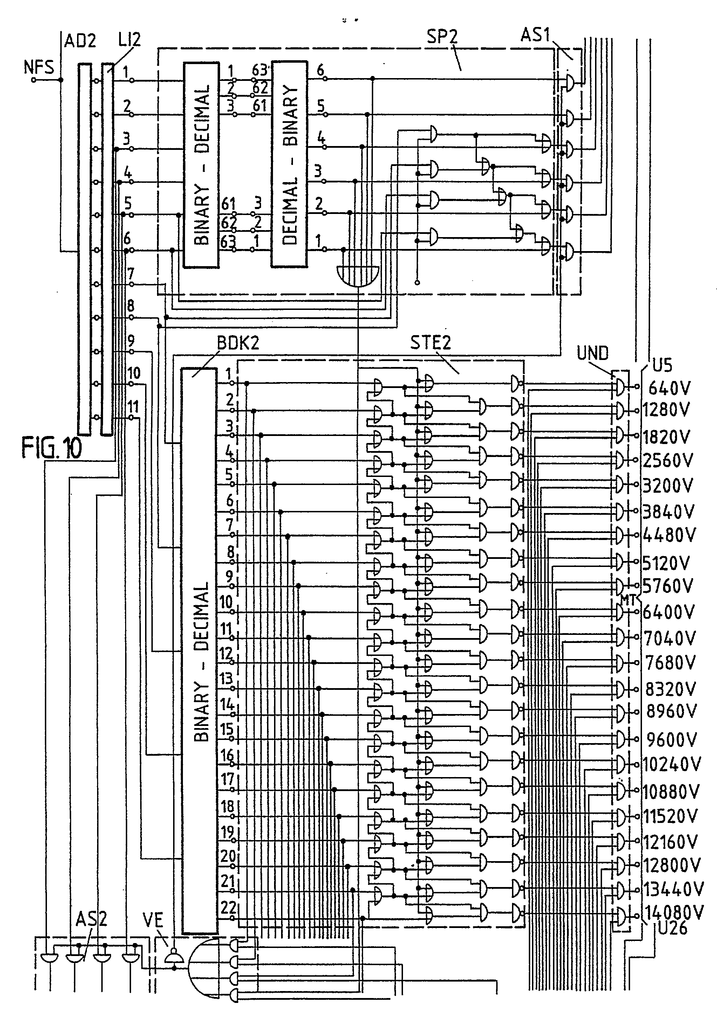

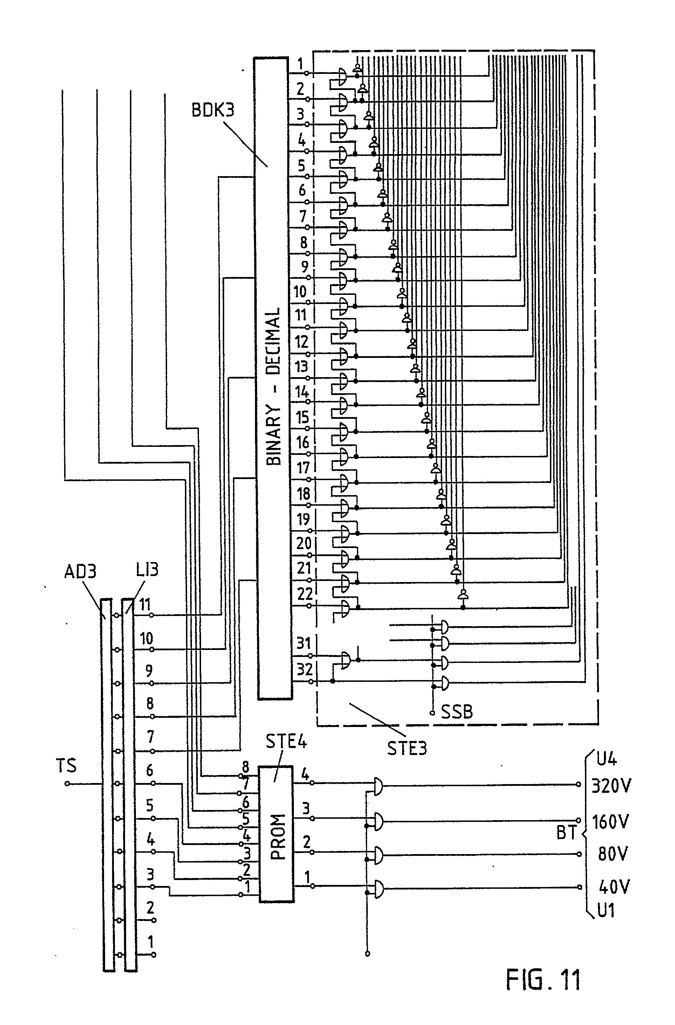

Die Figuren 9 bis 11 zeigen ein Ausführungsbeispiel, bei dem die Baugruppen, z.B. STE1, SP2, gemäß Fig. 8 durch derzeit käufliche Logikbauelemente, z.B. Gatter sowie Binär-Dezimal-Wandler, ausgeführt sind.

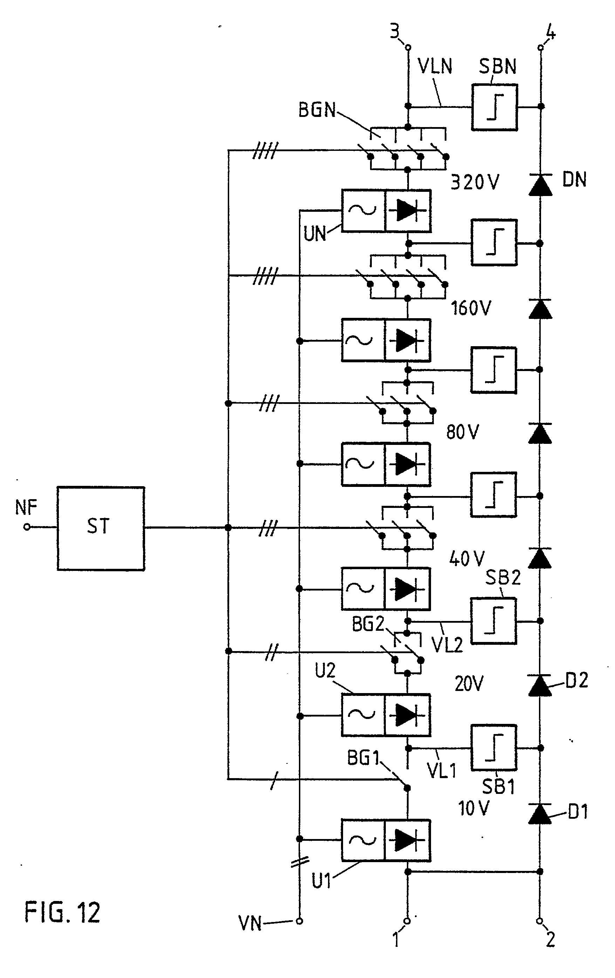

In dem Ausführungsbeispiel gemäß Fig. 12 ist eine Schaltungsanordnung beschrieben, bei der durch ein zu verstärkendes Niederfrequenz (NF)-Signal mehrere, in Reihe schaltbare Teilspannungsquellen schaltbar sind, die binär gewichtete Teilgleichspannungen erzeugen. Unter Berücksichtigung von derzeit üblichen Spannungs- und Qualitätsmerkmalen, z.B. einer zu erzeugenden NF-Wechselspannung mit Spitze-Spitze-Amplitudenwerten von ungefähr 30 kV und einem Klirrfaktor kleiner 1% bei Modulationsverstäkern von Rundfunksendern und unter Berücksichtigung derzeit zulässiger Maximalspannungswerte von ungefähr 1,2 kV für Leistungs-Halbleiterschalter ergibt sich für eine beispielhaft gewählte binäre Stufenzahl n = 6 ein minimaler Feinstufenwert $U_{min} = 10$ V für eine von dem NF-Signal angesteuerte Teilspannungsquelle. Damit ergibt sich für die weiterhin vorhandenen Maximalspannungsquellen ein Maximal-Spannungswert $U_{max} = 2^6 \cdot 10$ V = 640 V.

Bei AM-Rundfunksendern beträgt die niederfrequente Übertragungsbandbreite derzeit im allgemeinen ca. 5 kHz. Zur Vermeidung störender Aussendungen des Rundfunksenders infolge digitaler Schaltvorgänge bei dem Modulationsverstärker, muß dem Modulationsverstärker ein Tiefpaßfilter nachgeschaltet werden, dessen Grenzfrequenz oberhalb der höchsten zu übertragenden Niederfrequenz und unterhalb der Schaltfrequenz liegt. Je höher die Schaltfrequenz liegt, desto einfacher und daher kostengünstiger kann das Tiefpaßfilter ausgeführt werden, jedoch steigen mit höherer Schaltfrequenz die Schaltverluste des Verstärkers. Wählt man kompromißweise für die Grenzfrequenz des Tiefpaßfilter $f_g$ = 20 kHz und für die Schaltfrequenz $f_s$ = 80 kHz, so bedeutet dies für die schaltbaren Spannungsquellen einer Binärstufenanordnung eine maximale Schaltfrequenz von $f_s/2$ = 40 kHz.

Dies ist für Leistungshalbleiterschalter ein sehr hoher Wert. Leistungshalbleiterschalter für eine Schaltfrequenz von 10 kHz sind hingegen derzeit relativ leicht zu realisieren und daher kostengünstig herstellbar.

Die Figur 12 zeigt das Blockschaltbild einer beispielhaften Schaltungsanordnung, die aus sechs in Reihe schaltbaren Teilspannungsquellen U1 bis UN (N = 6) besteht. Jede Teilspannungsquelle wird aus dem Versorgungsnetz VN, z. B. 220 V, 50 Hz, über eine Zweidrahtleitung gespeist und enthält eine Gleichrichteranordnung. Die jeweils erzeugten Gleichspannungen sind ausgehend von dem minimalen Feinstufenwert $U_{min}$ = 10 V binär gewichtet und betragen entsprechend der dargestellten Zahlenreihe 10 V bis 320 V. Diese Teilgleichspannungen sind über eine Diodenkaskade D1 bis DN addierbar, so daß an den Gleichspannungsausgängen 3, 4 gegenüber den Gleichspannungseingängen 1, 2 eine maximale Gleichspannung von 630 V, in minimalen Stufen von 10 V, erzeugbar ist. Die Verbindungsleitungen VL1 bis VLN zwischen den Teilspannungsquellen U1 bis UN und den zugehörigen Dioden der Diodenkaskade D1 bis DN enthalten jeweils einen Spitzenstrombegrenzer SB1 bis SBN, dessen Ausgestaltung in den Figuren 2 bis 4 näher beschrieben ist und der im wesentlichen entstehende störende Kommutierungsstromspitzen auf eine nicht störende maximale Stromstärke begrenzt.

Bei jeder Teilspannungsquelle U1 bis UN ist jeweils die Gleichrichteranordnung in Reihe geschaltet mit einer Schaltergruppe BG1 bis BGN, so daß die jeweils erzeugte Gleichspannung schaltbar ist. Mindestens eine der Schalter gruppen BG1 bis BGN wird von getrennt steuerbaren, parallel geschalteten Halbleiterschaltern gebildet. Die Anzahl der jeweils parallel zu schaltenden Halbleiterschalter wird aus dem Verhältnis von Schaltfrequenz einer Schaltergruppe zur maximal zulässigen Schaltfrequenz der Halbleiterschalter bestimmt. Die Zahl der parallel geschalteten Halbleiterschalter in den einzelnen Schaltergruppen kann dabei unterschiedlich sein. So könnten z. B. in allen Gruppen mit kleineren binären Spannungswerten, wegen der geringeren Schaltverluste und der Verfügbarkeit schnellerer Halbleiterschalter für kleinere Spannungen, weniger Halbleiterschalter parallel geschaltet werden als bei den Schaltergruppen mit hohen Spannungswerten. Die Steuerung der einzelnen Halbleiterschalter in den verschiedenen Schaltergruppen wird von einer Steuereinheit ST durchgeführt, an deren Eingang das NF-Signal oder ein dementsprechendes Signal anliegt und von deren Ausgang mehradrige Steuerleitungen zu den Schaltergruppen führen.

Eine möglichst gleichmäßige zeitliche Verteilung der Verlustleistung der Halbleiterschalter wird dadurch erreicht, daß die parallel geschalteten Halbleiterschalter der Reihe nach ein- und ausgeschaltet werden und die jeweils am längsten nicht beanspruchten Halbleiterschalter der Schaltergruppen wieder zuerst eingeschaltet werden. Damit wird nicht nur eine optimale zeitliche Verteilung der Schaltverluste auf die einzelnen Halbleiterschalter erreicht, sondern gleichzeitig das für Halbleiterschalter in Schaltungsanordnungen mit Freilaufdioden wegen deren hohen Kommutierungsströme nachteilige sofortige Wiedereinschalten eines gerade ausgeschalteten Halbleiterschalters vermieden.

Die beschriebene Schaltungsanordnung ist vorteilhafterweise für eine Gruppe von Teilspannungsquellen einsetzbar, die als Binärgruppe für das NF-Signal bezeichnet ist.

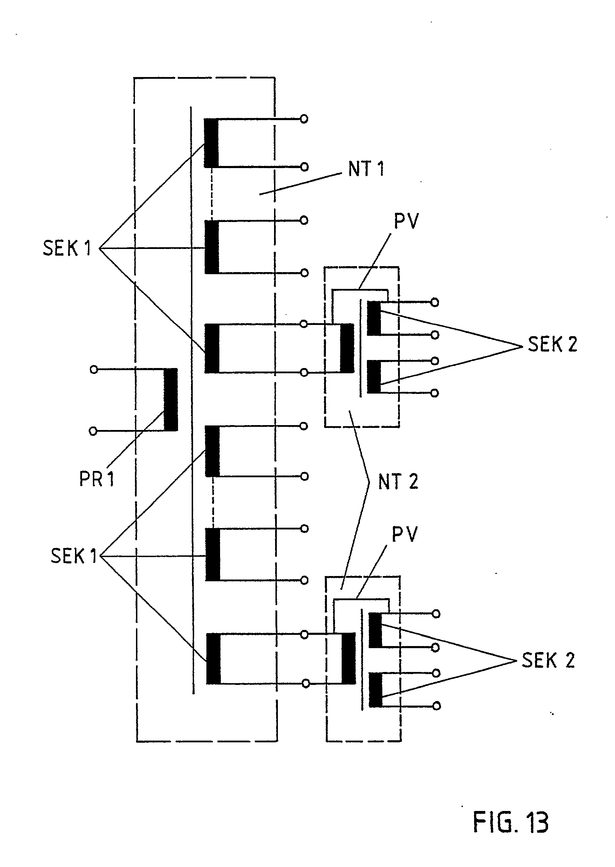

Fig. 13 zeigt ein Ausführungsbeispiel eines Netztransformators zur Herstellung der Teilspannungsquellen U1 bis UN gemäß Fig. 1. Der dargestellte Netztransformator besteht aus einem ersten Netztransformator NT1, dessen Primärwicklung PR1 z.B. an ein 380V, 50Hz Netz oder alternativ an ein entsprechendes Drehstromnetz angeschlossen ist.

An die ersten Sekundärwicklungen SEK1 sind nicht dargestellte Gleichrichter sowie nachgeschaltete Siebglieder anschließbar, so daß die Teilspannungsquellen herstellbar sind.

In einigen Anwendungsfällen ist es vorteilhaft, an mindestens eine der ersten Sekundärwicklungen SEK1 die Primärwicklung eines zweiten Netztransformators NT2 anzuschließen. Dieser besitzt mindestens eine zweite Sekundärwicklung SEK2, die ebenfalls zur Herstellung einer Teilspannungsquelle dient.

Zur Herstellung eines vorteilhaften elektrischen Potentialausgleichs ist zwischen mindestens einer zweiten Sekundärwicklung SEK2 und der Primärwicklung des zweiten Netztransformators NT2 oder alternativ mindestens einer ersten Sekundärwicklung SEK1 eine elektrisch leitende Potentialverbindung PV angebracht.

**Patentansprüche**

1. Schaltverstärker, insbesondere zur Erzeugung einer amplitudenmodulierten Anodenspannung für einen Hochfrequenz-Hochleistungssender, bestehend aus- einer ersten Reihenschaltung von mehreren schaltbaren Teilspannungsquellen (U1 bis UN),
- mehereren Freilaufdioden (D1 bis DN), deren Anzahl zumindest derjenigen der Teilspannungsquellen (U1 bis UN) entspricht, in einer zweiten Reihenschaltung, an deren Ausgängen eine Last (R) anschließbar ist,
- mehreren Verbindungsleitungen (VL1 bis VLN), die jeweils einen Verknüpfungspunkt der Teilspannungsquellen (U1 bis UN) mit einem zugehörigen Verknüpfungspunkt der Freilaufdioden (D1 bis DN) verbinden, und
- einer Steuereinheit (ST), welche die Teilspannungsquellen (U1 bis UN) schaltet nach Maßgabe eines zu verstärkenden Niederfrequenz-Signales (NF), das am Eingang der Steuereinheit (ST) anliegt,

<u>dadurch gekennzeichnet,</u>

- daß in mindestens einer der Verbindungsleitungen (VL1 bis VLN) ein Spitzenstrombegrenzer (SB1 bis SBN) vorhanden ist,

- daß die Anzahl der Teilspannungsquellen (U1 bis UN) sowie die jeweils erzeugten Einzelspannungen in Abhängigkeit von den zulässigen Verzerrungen der Ausgangsspannung gewählt sind,

- daß die Steuereinheit (ST) einen von der Übertragungseigenschaft des Schaltverstärkers abhängigen Linearisierer (LI) enthält und

- daß die Steuereinheit (ST) zumindest in Abhängigkeit von der Polarität und der Amplitude eines Eingangs-Wechselspannungssignals gleiche und unterschiedliche Spannungsquellen schaltet.

2. Schaltverstärker nach Anspruch 1, dadurch gekennzeichnet, daß der Ausgang (A) des Schaltverstärkers über ein Tiefpaßfilter (TP) mit einer Last (R) verbunden ist, die als anodenmodulierte Hochfrequenzendstufe eines Rundfunksenders ausgebildet ist, und daß die Teilspannungsquellen (U1 bis UN) von der Steuereinheit (ST) nach Maßgabe der einstellbaren Betriebsart geschaltet werden.

3. Schaltverstärker nach Anspruch 1 oder Anspruch 2, dadurch gekennzeichnet,

- daß der Steuereinheit (ST) ein zu verstärkendes Niederfrequenz-Signal (NF), ein Hochfrequenzsignal (RF), welches die Trägerfrequenz enthält, sowie ein am Ausgang (A) abgegriffenes Vergleichssignal (VS) zugeführt werden,

- daß in der Steuereinheit (ST) eine Signal-Aufbereitungsschaltung (SA), eine Niederfrequenz-Aufbereitungsschaltung (NA) sowie eine Träger-Aufbereitungsschaltung (TA) enthalten sind, in denen in Abhängigkeit von der Betriebsart ein Niederfrequenz-Steuersignal (NFS) sowie ein Träger Steuersignal (TS) erzeugt und einer Schalteinheit (SE) zugeführt werden,

- daß der Linearisierer (LI) aus dem Vergleichssignal (VS) ein Korrektursignal (KS) erzeugt, das der Schalteinheit (SE) zugeführt wird,

- daß die Teilspannungsquellen (U1 bis UN) in mindestens eine Niederfrequenzgruppe (BNF, MNF) sowie mindestens eine Trägergruppe (BT, MT) aufgeteilt sind

- daß die Schalteinheit (SE) eine der Anzahl der Teilspannungsquellen (U1 bis UN) entsprechende Anzahl von Ausgängen besitzt, die mit den Teilspannungsquellen (U1 bis UN) verbunden sind,

- daß die Schalteinheit (SE) in Abhängigkeit von dem Korrektursignal (KS) und dem Niederfrequenz-Steuersignal (NFS) die Niederfrequenzgruppe (BNF, MNF) ansteuert und

- daß die Schalteinheit (SE) in Abhängigkeit von dem Korrektursignal (KS), dem Träger-Steuersignal (TS) und dem Niederfrequenz-Steuersignal (NFS) die Trägergruppe (BT, MT) ansteuert.

4. Schaltverstärker nach einem der vorhergehenden Ansprüche, dadurch gekennzeichnet,

- daß als Betriebsart ein Doppelseitenbandbetrieb mit oder ohne dynamikgesteuerter Amplitudenmodulation oder ein Einseitenbandbetrieb wählbar ist,

- daß an der Steuereinheit (ST) eine einem Nenn- oder Teilleistungsbetrieb entsprechende Ausgangsspannung einstellbar ist.

- daß bei Einseitenbandbetrieb in der Steuereinheit (ST) aus dem Niederfrequenzsignal (NF) und dem Hochfrequenzsignal (RF) ein Einseitenband-Hüllkurvensignal, aus dem RF-Signal ein Trägerwertsignal und aus diesen beiden Signalen ein Signal gewonnen wird, das verstärkt wird durch die von der Schalteinheit (SE) geschalteten Teilspannungsquellen (U1 bis UN), und

- daß bei Doppelseitenbandbetrieb das Niederfrequenzsignal verstärkt wird durch die von der Schalteinheit (SE) geschalteten Teilspannungsquellen (U1 bis UN), wobei bei einer dynamikgesteuerten Amplitudenmodulation das Trägersteuersignal (TS) in Abhängigkeit von der Dynamik des Niederfrequenzsignals (NF) gesteuert wird.

5. Schaltverstärker nach einem der vorhergehenden Ansprüche, dadurch gekennzeichnet, daß zumindest das Niederfre quenz-Steuersignal (NFS) sowie das Träger-Steuersignal (TS) als digitale Pegelwerte vorliegen, an denen durch mindestens einen Linearisierer (LI) eine Pegelkorrektur erfolgt und an denen außerdem eine Pegelbewertung vorgenommen wird derart, daß am Ausgang (A) ein verzerrungsarmes Ausgangssignal entsteht.

6. Schaltverstärker nach einem der vorhergehenden Ansprüche, dadurch gekennzeichnet,

- daß die Niederfrequenzgruppe (BNF, MNF) in mindestens eine Binär-Niederfrequenzgruppe (BNF) und mindestens eine Maximal-Niederfrequenzgruppe (MNF) aufgeteilt ist,

- daß die Trägergruppe (BT, MT) in mindestens eine Binär-Trägergruppe (BT) und mindestens eine Maximal-Trägergruppe (MT) aufgeteilt ist,

- daß die Trägerspannung die Trägergruppe (BT, MT) ansteuert,

- daß bei einer positiven Halbwelle eines Eingangs-Wechselspannungssignals lediglich die Niederfrequenzgruppe (BNF, MNF) angesteuert wird,

- daß bei einer negativen Halbwelle des Eingangs-Wechselspannungssignals die Trägergruppe (BT, MT) zusätzlich angesteuert wird,

- daß in der Binär-Niederfrequenzgruppe (BNF) bzw. in der Binär-Trägergruppe (BT) jeweils Einzelspannungsquellen vorhanden sind, die jeweils Einzelspannungen erzeugen, die wesentlich kleiner sind als diejenigen der Maximal-Niederfrequenzgruppe (MNF) bzw. der Maximal-Trägergruppe (MT)

- daß bei kleinen bzw. großen Änderungen der Niederfrequenzspannung sämtliche Binär- und Maximal-Niederfrequenzgruppen bzw. nur höherwertige Binär- und Maximal-Niederfrequenzgruppen gesteuert werden,

- daß bei kleinen bzw. großen Änderungen der Trägerspannung sämtliche Binär- und Maximal-Trägergruppen bzw. nur höherwertige Binär- und Maximal-Trägergruppen gesteuert werden.

7. Schaltverstärker nach einem der vorhergehenden Ansprüche, dadurch gekennzeichnet, daß bei Einseitenbandbetrieb ein Komparator eingeschaltet ist, der aus einem Einseitenband-Hüllkurvensignal und einem Einseitenband-Trägerwertsignal eine Steuerspannung bildet, welche über die Schalteinheit (SE) die Niederfrequenzgruppe (BNF, MNF) ansteuert.

8. Schaltverstärker nach einem der vorhergehenden Ansprüche, dadurch gekennzeichnet,
- daß in der Maximal-Niederfrequenzgruppe (MNF) und der Maximal-Trägergruppe (MT) jeweils gleiche Spannungsquellen vorhanden sind
- daß in der Binär-Niederfrequenzgruppe (BNF) und der Binär-Trägergruppe (BT) jeweils binär gestufte Spannungsquellen vorhanden sind, wobei eine signalpegelabhängige Stufung der Ausgangsspannung durch Pegelbewerter erfolgt, die eine digitale Pegelinformation so bewerten, daß deren höherwertige Bit's niederwertige Spannungsquellen der Binärgruppen sperren und
- daß die höherwertigen Bits über Binär-Dezimal-Konverter den zu schaltenden Spannungsquellen zugeführt werden.

9. Schaltverstärker nach einem der vorhergehenden Ansprüche, dadurch gekennzeichnet, daß bei einer Änderung des Eingangssignales lediglich die diesen Änderungs-Spannungswert erzeugenden Spannungsquellen geschaltet werden.

10. Schaltverstärker nach einem der vorhergehenden Ansprüche, dadurch gekennzeichnet, daß der Linearisierer (LI) eine programmierbare digitale Speicheranordnung enthält, deren Adressen einem digitalen Steuerspannungseingangswert zugeordnet sind und deren Speicherinhalt einem korrigierten Steuerspannungsausgangswert zugeordnet ist,
- daß der Steuerspannungseingangwert von dem Vergleichssignal (VS) abgeleitet ist und
- daß aus dem Steuerspannungsausgangssignal das Korrektursignal (KS) erzeugt wird.

11. Schaltverstärker nach einem der vorhergehenden Ansprüche, dadurch gekennzeichnet, daß mindestens ein Spitzenstrombegrenzer (SB1 bis SBN) als Widerstand oder einer Parallelschaltung aus einem Widerstand und einer Induktivität und/oder aus einer Parallelschaltung aus einem Widerstand und einer Induktivität besteht, bei welchen Bauelementen mindestens eine Diode in Reihe geschaltet ist (Fig. 2 bis 4).

12. Schaltverstärker nach eimem der vorhergehenden Ansprüche, dadurch gekennzeichnet, daß zum Schalten der Teilspannungsquellen (U1 bis UN) mindestens eine Reihenschaltung aus mindestens zwei Halbleiterschaltern vorhanden ist und/oder mindestens eine Parallelschaltung aus mindestens zwei Reihenschaltungen von jeweils mindestens zwei Halbleiterschaltern (Fig. 5, 6).

13. Schaltverstärker nach einem der vorhergehenden Ansprüche, dadurch gekennzeichnet,
- daß zumindest eine Teilspannungsquelle (U2), die durch das Niederfrequenz-Signal (NF) ansteuerbar ist, durch eine Schaltergruppe (BG2) schaltbar ist,
- daß die Schaltergruppe (BG2) aus mindestens zwei parallel geschalteten Halbleiterschaltern besteht,
- daß die Halbleiterschalter unabhängig voneinander ein- sowie ausschaltbar sind,
- daß für einen ersten Schaltvorgang lediglich eine Teilzahl der Halbleiterschalter benutzt wird und
- daß für einen zeitlich nachfolgenden zweiten Schaltvorgang mindestens ein Halbleiterschalter benutzt wird, der bei dem ersten Schaltvorgang unbenutzt geblieben ist.

14. Schaltverstärker nach einem der vorhergehenden Ansprüche, dadurch gekennzeichnet, daß die in einer Schaltergruppe vorhandene Anzahl der Halbleiterschalter in Abhängigkeit von der zulässigen Verlustleistung und der maximal zulässigen Schaltfrequenz eines einzelnen Halbleiterschalters gewählt ist.

15. Schaltverstärker nach Anspruch 1, dadurch gekennzeichnet, daß die Halbleiterschalter innerhalb einer Schaltergruppe nacheinander ein- und ausgeschaltet werden und die Wiedereinschaltung jeweils der Halbleiterschalter der Schaltgruppen erfolgt, die die längste Zeit ausgeschaltet oder am geringsten verlustleistungsmäßig beansprucht waren.

16. Schaltverstärker nach einem der vorhergehenden Ansprüche, dadurch gekennzeichnet,
- daß ein erster Netztransformator (NT1) vorhanden ist mit einer ersten Primärwicklung und mindestens einer ersten Sekundärwicklung (SEK1)
- daß an mindestens eine der ersten Sekundärwicklungen die Primärwicklung eines zweiten Netztransformators (NT2) angeschlossen ist, der mindestens eine zweite Sekundärwicklung (SEK2) besitzt und
- daß die zweite Sekundärwicklung (SEK2) zur Versorgung mindestens einer Teilspannungsquelle dient (FIG. 13).

17. Schaltverstärker nach Anspruch 16, dadurch gekennzeichnet, daß zwischen mindestens einer zweiten Sekundärwicklung (SEK2) und mindestens einer ersten Sekundärwicklung (SEK1) eine elektrisch leitende Potentialverbindung (PV) vorhanden ist (FIG. 13).

**Claims**

1. Switching amplifier, in particular for the production of an amplitude-modulated anode voltage for a high-frequency high-power transmitter, consisting of
- a first series connection of several switchable partial sources (U1 to UN),
- several freewheel diodes (D1 to DN), the number of which corresponds to at least that of the partial voltage sources (U1 to UN), in a second series connection and to the outputs of which a load (R) is connectable,
- several connecting lines (VL1 to VLN), which each connect a respective junction of the partial voltage sources (U1 to UN), with an associated junction of the freewheel diodes (D1 to DN), and
- a control unit (ST), which switches the partial voltage sources (U1 to UN) in accordance with a low-frequency signal (NF), which is to be amplified and present at the input of the control unit (ST), characterised thereby,
- that a peak current limiter (SB1 to SBN) is present in at least one of the connecting lines (VL1 to VLN),
- that the number of the partial voltage sources (U1 to UN) as well as the respectively produced individual voltages are chosen in dependence on the permissible distortions of the output voltage,
- that the control unit (ST) contains a lineariser (L1) dependent on the transmission property of the switching amplifier and,
- that the control unit (ST) switches like and different voltage sources at least in dependence on the polarity and the amplitude of an alternating voltage input signal.

2. Switching amplifier according to claim 1, characterised thereby, that the output (A) of the switching amplifier is connected by way of a low-pass filter (TP) with a load (R), which is constructed as anode-modulated high-frequency output stage of a radio transmitter, and that the partial voltage sources (U1 to UN) are switched by the control unit (ST) in accordance with a settable mode of operation.

3. Switching amplifier according to claim 1 or claim 2, characterised thereby,
- that a low-frequency signal (NF) to be amplified and a high-frequency signal (RF) containing the carrier frequency as well as a comparison signal (V2), which is taken off at the output (W), are conducted to the control unit (ST),
- that a signal preparation circuit (SA), a low-frequency preparation circuit (NA) as well as a carrier preparation circuit (TA), in which a low-frequency control signal (NFS) as well as a carrier control signal (TS) are produced in dependence on the mode of operation and conducted to a switching unit (SE), are contained in the control unit (ST),
- that the lineariser (1) produces a correction signal (KS), which is conducted to the switching unit (SE), from the comparison signal (VS),
- that the partial voltage sources (U1 to UN) are divided up into at least one low-frequency group (BNF, MNF) as well as at least one carrier group (BT, MT),
- that the switching unit (SE) possesses a number, which corresponds to the number of the partial voltage sources (U1 to UN), of outputs which are connected with the partial voltage sources (U1 to UN),
- that the switching unit (SE) drives the low-frequency group (BNF, MNF) in dependence on the correction signal (KS) and the low-frequency control signal (NF2) and
- that the switching unit (SE) drives the carrier group (BT, MT) in dependence on the correction signal (KS), the carrier control signal (TS) and the low-frequency control signal (NFS).

4. Switching amplifier accordingly to one of the preceding claims, characterised thereby,
- that a double-sideband operation with or without dynamic-range-controlled amplitude modulation or a single-sideband operation is selectable as mode of operation,
- that an output voltage, which corresponds to a nominal power operation or to a partial power operation, is settable at the control unit (ST),
- that in the case of single-sideband operation, a single-sideband envelope signal is obtained in the control unit (ST) from the low-frequency signal (NF) and the high-frequency signal (RF), a carrier value signal is obtained in the control unit (ST) from the RF-signal and a signal is obtained in the control unit (ST) from both these signals, which is amplified by the partial voltage sources (U1 to UN) switched by the switching unit (SE), and
- that in the case of double-sideband operation, the low-frequency signal is amplified by the partial voltage sources (U1 to UN) switched by the switching unit (SE), wherein the carrier control signal (TS) is controlled in dependence on the dynamic range of the low-frequency signal (NF) in the case of a dynamic-range-controlled amplitude modulation.

5. Switching amplifier according to one of the preceding claims, characterised thereby, that at least the low-frequency control signal (NFS) as well as the carrier control signal (TS) are present as digital level values, of which a level correction takes place by at least one lineariser (L1), and of which a level weighting is undertaken beyond that in such a manner that a low-distortion output signal arises at the output (A).

6. Switching amplifier according to one of the preceding claims, characterised thereby,
- that the low-frequency group (BNF, MNF) is divided up into at least one binary low-frequency group (BNF) and at least one maximum low-frequency group (MNF),
- that the carrier group (BT, MT) is divided up into at least one binary carrier group (BT) and at least one maximum carrier group (MT),
- that the carrier voltage drives the carrier group (BT, MT),
- that merely the low-frequency group (BNF, MNF) is driven in the case of a positive half-wave of an alternating voltage input signal,
- that additionally the carrier group (BT, MT) is driven in the case of a negative half-wave of the alternating voltage input signal,
- that respective individual voltage sources are present in the binary low-frequency group (BNF) and the binary carrier group (BT) and produce respective individual voltages which are substantially smaller than those respectively of the maximum low-frequency group (MNF) and the maximum carrier group (MT),
- that either all binary and maximum low-frequency groups or only higher value binary and maximum low-frequency groups are controlled respectively for small or large changes in the low-frequency voltage and
- that either all binary and maximum carrier groups or only higher value binary and maximum carrier groups are controlled respectively for small or large changes in the carrier voltage.

7. Switching amplifier according to one of the preceding claims, characterised thereby, that a comparator is switched in for single-sideband operation and forms a control voltage, which by way of the switching unit (SE) drives the low-frequency group (BNF, MNF), out of a single-sideband envelope curve signal and a single-sideband carrier value signal.

8. Switching amplifier according to one of the preceding claims, characterised thereby,
- that like voltage sources are respectively present in the maximum low-frequency group (MNF) and the maximum carrier group (MT),

- that binarily stepped voltage sources are respectively present in the binary low-frequency group (BNF) and the binary carrier group (BT), wherein a gradation of the output voltage takes place in dependence on signal level by level weighting devices which so weight a digital level information signal that its higher value bits block lower value voltage sources of the binary groups and

- that the higher value bits are conducted by way of binary-to-decimal converters to the voltage sources to be switched.

9. Switching amplifier according to one of the preceding claims, characterised thereby, that in the case of a change in the input signal, merely the voltage sources producing this change voltage value are switched.

10. Switching amplifier according to one of the preceding claims, characterised thereby,
- that the lineariser (L1) contains a programmable digital storage arrangement, the addresses of which are associated with a digital control voltage input value and the storage content of which is associated with a corrected control voltage output value,
- that the control voltage input value is derived from the comparison signal (VS) and
- that the correction signal (KS) is produced out of the control voltage output signal.

11. Switching amplifier according to one of the preceding claims, characterised thereby, that at least one peak current limiter (SB1 to SBN) consists of a resistor or of a parallel connection of a resistor and an inductor and/or of a parallel connection of a resistor and an inductor, in the case of which components at least one diode is connected in series (Figs. 2 to 4).

12. Switching amplifier according to one of the preceding claims, characterised thereby, that at least one series connection of at least two semiconductor switches and/or at least one parallel connection of at least two series connections each of at least two semiconductor switches is present for the switching of the partial voltage sources (U1 to UN) (Figs. 5 and 6).

13. Switching amplifier according to one of the preceding claims characterised thereby,
- that at least one partial voltage source (U2), which is drivable by the low-frequency signal (NF), is switchable by a switch group (BG2),
- that the switch group (BG2) consists of at least two parallelly connected semiconductor switches,
- that the semiconductor switches are switchable on as well as off one independently of the other,
- that merely a partial number of the semiconductor switches is used for a first switching operation and
- that at least one semiconductor switch, which has remained unused during the first switching operation, is used for a second switching operation following in time.

14. Switching amplifier according to one of the preceding claims, characterised thereby, that the number of the semiconductor switches present in a switch group is chosen in dependence on the permissible power loss and the maximum permissible switching frequency of a single semiconductor switch.

15. Switching amplifier according to claim 1, characterised thereby, that the semiconductor switches within a switch group are switched on and off after the other and the renewed switching-on takes place each time of the semiconductor switches of the switch groups which have been switched off for the longest time or been stressed least in terms of power loss.

16. Switching amplifier according to one of the preceding claims characterised thereby,
- that a first mains transformer (NT1) with a first primary winding and at least one first secondary winding (SEK1) is present,
- that the primary winding of a second mains transformer (NT2), which possesses at least one second secondary winding (SEK2), is connected to at least one of the first secondary windings and
- that the second secondary winding (SEK2) serves for the supply of at least one partial voltage source (Fig. 13).

17. Switching amplifier according to claim 16, characterised thereby, that an electrically conducting potential connection (PV) is present between at least one second secondary winding (SEK2) and at least one first secondary winding (SEK1) (Fig. 13).

**Revendications**

1. Amplificateur à commutation, en particulier pour produire une tension d'anode, modulée en amplitude, pour un émetteur haute puissance, haute fréquence, comportant
- un premier circuit de série formé de plusieurs sources, commutables, de tension partielle (U1 à UN),
- plusieurs diodes à passage à sens unique (D1 à DN), dont le nombre correspond au moins à celui des sources de tension partielle (U1 à UN), dans un second circuit de série aux sorties duquel peut être reliée une charge (R),
- plusieurs conducteurs de liaison (VL1 à VLN) qui relient respectivement un nœud des sources de tension partielle (U1 à UN) avec un nœud correspondant des diodes à passage à sens unique (D1 à DN) et
- une unité de commande (ST) qui met en circuit/hors circuit les sources de tension partielle (U1 à UN) en fonction d'un signal basse fréquence à amplifier (NF) qui apparaît à l'entrée de l'unité de commande (ST), caractérisé
- par le fait que dans au moins l'un des conducteurs de liaison (VL1 à VLN) se trouve un limiteur de courant de pointe (SB1 à SBN),
- par le fait que l'on choisit le nombre des sources de tension partielle (U1 à UN) ainsi que les différentes tensions respectivement produites en fonction des distorsions autorisées de la tension de sortie,
- par le fait que l'unité de commande (ST) contient un organe de linéarisation (L1) qui est fonction de la caractéristique de transmission de l'amplificateur à commutation et

- par le fait que l'unité de commande (ST) met en circuit/hors circuit des sources de tension identiques et différentes au moins en fonction de la polarité et de l'amplitude d'un signal de tension alternative d'entrée.

2. Amplificateur à commutation selon la revendication 1, caractérisé par le fait que la sortie (A) de l'amplificateur à commutation est reliée, par l'intermédiaire d'un filtre passe-bas (TP), à une charge (R) qui est conçue en tant qu'étage haute fréquence, à modulation d'anode, d'un émetteur radio; et par le fait que les sources de tension partielle (U1 à UN) peuvent être mises en circuit/hors circuit par l'unité de commande (ST) en fonction du mode opératoire, modifiable.

3. Amplificateur à commutation selon la revendication 1 ou la revendication 2, caractérisé

- par le fait qu'à l'unité de commande (ST) on amène un signal basse fréquence à amplifier (NF), un signal haute fréquence (RF) qui contient la fréquence porteuse, ainsi qu'un signal de comparaison (VS) prélevé à la sortie (A),

- par le fait que dans l'unité de commande (ST) sont contenus un circuit (SA) de préparation du signal, un circuit (NA) de préparation du signal basse fréquence, ainsi qu'un circuit (TA) de préparation de la fréquence porteuse, circuits dans lesquels, en fonction du mode opératoire, sont produits, et amenés à une unité de commutation (SE), un signal de commande (NFS) fonction du signal basse fréquence ainsi qu'un signal de commande (TS) fonction de la fréquence porteuse,

- par le fait que l'organe de linéarisation (L1) produit, à partir du signal de comparaison (VS), un signal de correction (KS) qui est amené à l'unité de commutation (SE),

- par le fait que les sources de tension partielle (U1 à UN) sont réparties en au moins un groupe basse fréquence (BNF, MNF) ainsi qu'en au moins un groupe fréquence porteuse (BT, MT),

- par le fait que l'unité de commutation (SE) possède un nombre, correspondant au nombre des sources de tension partielle (U1 à UN), de sorties qui sont reliées avec les sources de tension partielle (U1 à UN),

- par le fait que l'unité de commutation (SE) pilote le groupe basse fréquence (BNF, MNF) en fonction du signal de correction (KS) et du signal de commande (NFS) fonction du signal basse fréquence et

- par le fait que l'unité de commutation (SE) pilote le groupe fréquence porteuse (BT, MT) en fonction du signal de correction (KF), du signal de commande (TS) fonction de la fréquence porteuse et du signal de commande (NFS) fonction de la basse fréquence.

4. Amplificateur à commutation selon l'une des revendications précédentes, caractérisé

- par le fait que, comme mode opératoire, on peut choisir le mode opératoire à double bande latérale avec ou sans modulation d'amplitude à commande dynamique ou bien le mode opératoire à bande latérale unique,

- par le fait que sur l'unité de commande (ST) on peut prescrire une tension de sortie correspondant à une exploitation en puissance nominale ou à une exploitation en puissance partielle,

- par le fait qu'en mode opératoire à bande latérale unique, on obtient, dans l'unité de commande (ST), à partir du signal basse fréquence (NF) et du signal haute fréquence (RF), un signal bande latérale unique, mesuré sur la courbe enveloppe, ainsi qu'à partir du signal RF, un signal fonction de la fréquence porteuse, ainsi qu'à partir de ces deux signaux, un signal qui est amplifié par les sources de tension partielle (U1 à UN) mises en circuit/hors circuit par l'unité de commande (SE) et

- par le fait qu'en mode opératoire à double bande latérale, le signal basse fréquence est amplifié par les sources de tension partielle (U1 à UN) mises en circuit/hors circuit par l'unité de commande (SE), étant précisé que, dans le cas d'une modulation d'amplitude à commande dynamique, le signal de commande fonction de la fréquence porteuse (TS) est commandé en fonction de la dynamique du signal basse fréquence (NF).

5. Amplificateur à commutation selon l'une des revendications précédentes, caractérisé par le fait qu'au moins le signal de commande (NFS) fonction du signal basse fréquence ainsi que le signal de commande (TS) fonction de la fréquence porteuse se présentent sous forme de grandeurs numériques, pour lesquelles se fait une correction de valeur au moyen d'au moins un organe de linéarisation (L1) et pour lesquelles on procède en outre à une attribution de valeur de façon telle qu'à la sortie (A) apparait un signal de sortie présentant peu de distorsion.

6. Amplificateur à commutation selon l'une des revendications précédentes, caractérisé

- par le fait que le groupe basse fréquence (BNF, MNF) est réparti en au moins un groupe basse fréquence à échelonnement binaire (BNF) et au moins un groupe basse fréquence de tension maximale (MNF),

- par le fait que le groupe fréquence porteuse (BT, MT) est réparti en au moins un groupe fréquence porteuse à échelonnement binaire (BT) et au moins un groupe fréquence porteuse de tension maximale (MT),

- par le fait que la tension de la fréquence porteuse pilote le groupe fréquence porteuse (BT, MT),

- par le fait qu'en présence d'une demi-onde positive d'un signal de tension alternative d'entrée, seul le groupe basse fréquence est activé,

- par le fait qu'en présence d'une demi-onde négative du signal de tension alternative d'entrée, le groupe fréquence porteuse (BT, MT) est en outre activé,

- par le fait que dans le groupe basse fréquence à échelonnement binaire (BNF) ou dans le groupe fréquence porteuse à échelonnement binaire (BT) existent respectivement des sources de tension individuelle qui produisent respectivement des tensions individuelles qui sont sensiblement inférieures à celles du groupe basse fréquence de tension maximale (MNF) ou du groupe fréquence porteuse de tension maximale (MT),

- par le fait qu'en présence de faibles ou d'importantes modifications de la tension basse fréquence, tous les groupes basse fréquence à échelonnement binaire et tous les groupes basse fréquence de tension maximale sont activés, ou bien seuls les groupes basse fréquence à échelonnement binaire de poids fort et les groupes basse fréquence de tension maximale sont activés,

- par le fait qu'en présence de faibles ou importantes modifications de la tension de la fréquence porteuse, tous les groupes fréquence porteuse à échelonnement binaire et tous les groupes fréquence porteuse de tension maximale sont activés ou bien seuls les groupes fréquence porteuse à échelonnement binaire de poids fort et les groupes fréquence porteuse de tension maximale sont activés.

7. Amplificateur à commutation selon l'une des revendications précédentes, caractérisé par le fait qu'en mode opératoire à bande latérale unique est mis en circuit un comparateur qui, à partir d'un signal, mesuré sur la courbe enveloppe, à bande latérale unique et à partir d'un signal de la fréquence porteuse à bande latérale unique, forme une tension de commande qui active le groupe basse fréquence (BNF, MNF) par l'intermédiaire de l'unité de commutation (SE).

8. Amplificateur à commutation selon l'une des revendications précédentes, caractérisé

- par le fait que dans le groupe basse fréquence de tension maximale (MNF) et dans le groupe fréquence porteuse de tension maximale (MT) existent respectivement des sources de tension identiques,

- par le fait que dans le groupe basse fréquence à échelonnement binaire (BNF) et dans le groupe fréquence porteuse à échelonnement binaire (BT) existent respectivement des sources de tension à échelonnement binaire, étant précisé qu'un échelonnement, fonction de la valeur du signal, de la tension de sortie se fait au moyen d'organes d'attribution de valeur qui attribuent à une information numérique une valeur telle que ses bits de poids fort bloquent les sources de tension de faible valeur des groupes à échelonnement binaire et

- par le fait que les bits de poids fort sont amenés aux sources de tension à mettre en/hors circuit par l'intermédiaire de convertisseurs binaire-décimal.

9. Amplificateur à commutation selon l'une des revendications précédentes, caractérisé par le fait qu'en présence d'une modification du signal d'entrée, seules les sources de tension produisant une valeur de la tension correspondant à cette modification sont mises en circuit/hors circuit.

10. Amplificateur à commutation selon l'une des revendications précédentes, caractérisé par le fait que l'organe de linéarisation (L1) contient une mémoire numérique programmable dont les adresses correspondent à une valeur d'entrée numérique de la tension de commande et dont le contenu de mémoire correspond à une valeur de sortie, corrigée, de la tension de commande,

- par le fait que la valeur d'entrée de la tension de commande dérive du signal de comparaison (VS) et

- par le fait que le signal de correction (KS) est produit à partir du signal de sortie de la tension de commande.

11. Amplificateur à commutation selon l'une des revendications précédentes, caractérisé par le fait qu'au moins un limiteur d'intensité de pointe (SB1 à SBN) est constitué d'une résistance ou d'un circuit parallèle formé d'une résistance et d'une inductance et/ou d'un circuit parallèle formé d'une résistance et d'une inductance, composant avec lesquelles au moins une diode est montée en série (figures 2 à 4).

12. Amplificateur à commutation selon l'une des revendications précédentes, caractérisé par le fait que pour mettre en circuit/hors circuit les sources de tension partielle (U1 à UN) il existe au moins un circuit de série constitué d'au moins deux commutateurs à semi-conducteur et/ou au moins un circuit de série constitué d'au moins deux circuits de série formés de chacun au moins deux commutateurs à semi-conducteur (figures 5, 6).

13. Amplificateur à commutation selon l'une des revendications précédentes, caractérisé

- par le fait qu'au moins une source de tension partielle (U2), qui peut être activée par le signal basse fréquence (NF), peut être mise en circuit/hors circuit par un groupe de comutation (BG2),

- par le fait que le groupe de commutation (BG2) est constitué d'au moins deux commutateurs à semi-conducteur montés en parallèle,

- par le fait que les commutateurs à semi-conducteurs peuvent être mis en circuit ou hors circuit indépendamment l'un de l'autre,

- par le fait que pour un premier processus de mise en circuit/hors circuit on utilise simplement un nombre partiel des commutateurs à semi-conducteurs et

- par le fait que pour un second processus de mise en circuit/hors circuit qui vient à la suite dans le temps, on utilise au moins un commutateur à semi-conducteur qui est resté inutilisé lors du premier processus.

14. Amplificateur à commutation selon l'une des revendications précédentes, caractérisé par le fait que l'on choisit le nombre des commutateurs à semi-conducteur présents dans un groupe de commutation en fonction de la dissipation autorisée et de la fréquence de commutation maximale autorisée de chacun des commutateurs à semi-conducteur.

15. Amplificateur à commutation selon la revendication 1, caractérisé par le fait que les commutateurs à semi-conducteur qui sont à l'intérieur d'un groupe de commutateurs sont mis en circuit et hors circuit successivement et par le fait que la remise en circuit se fait chaque fois sur les commutateurs à semi-conducteur des groupes de commutateurs qui étaient restés hors circuit pendant la durée la plus longue ou bien qui avaient subi la contrainte de dissipation la plus faible.

16. Amplificateur à commutation selon l'une des revendications précédentes, caractérisé

- par le fait qu'il existe un premier transformateur d'alimentation sur secteur (NT1) comportant un premier bobinage primaire et au moins un premier bobinage secondaire (SEK1),

- par le fait qu'à au moins l'un des premiers bobinages secondaires est relié le bobinage primaire d'un second transformateur d'alimentation sur le secteur (W2) qui possède au moins un second bobinage secondaire (SEK2) et

- par le fait que le second bobinage secondaire (SEK2) sert à alimenter au moins une source de tension partielle (figure 13).

17. Amplificateur à commutation selon la revendication 16, caractérisé par le fait qu'entre au moins un second bobinage secondaire (SEK2) et au moins un premier bobinage secondaire (SEK1) existe une liaison de potentiel électriquement conductrice (PV) (figure 13).

FIG. 1

FIG.2

FIG.3

FIG.4    FIG.5    FIG.6

FIG.7

EP 0 218 152 B1

FIG. 8

FIG. 9

EP 0 218 152 B1

FIG.10

FIG. 11

FIG. 12

FIG. 13